Europäisches Patentamt

European Patent Office

Office européen des brevets

(11) Veröffentlichungsnummer: **0 023 275**

**A1**

(12) # EUROPÄISCHE PATENTANMELDUNG

(21) Anmeldenummer: **80103705.2**

(22) Anmeldetag: **30.06.80**

(51) Int. Cl.³: **H 04 B 1/40**
**H 03 F 3/26**

(30) Priorität: **27.07.79 DE 2930606**

(43) Veröffentlichungstag der Anmeldung:
**04.02.81 Patentblatt 81/5**

(84) Benannte Vertragsstaaten:
**AT CH FR GB IT LI NL SE**

(71) Anmelder: **Walter Dittel GmbH Luftfahrtgerätebau**
**Erpftinger Strasse 36 Postfach 260**
**D-8910 Landsberg/Lech 1(DE)**

(72) Erfinder: **Franz, Otto**
**Herzogstandstrasse 16**
**D-8910 Landsberg/Lech(DE)**

(74) Vertreter: **Patentanwälte Manitz, Finsterwald und**
**Grämkow**
**Robert-Koch-Strasse 1**
**D-8000 München 22(DE)**

(54) **Simplex-Sende-Empfangsgerät.**

(57) Simplex-Sende-Empfangsgerät mit einem Niederfrequenz-Leistungsverstärker (11), welcher bei der Betriebsart "Empfang" die vom Empfänger (17) empfangenen und demodulierten Hochfrequenzsignale verstärkt und bei der Betriebsart "Senden" als Modulator für den Sender (23) geschaltet ist. Der Niederfrequenz-Leistungsverstärker weist eine Gegentaktendstufe auf. Zur Reduzierung der Übergangsverzerrungen wird ein Ruhestrom symmetrisch in die Gegentaktendstufe eingeleitet und zwar derart, daß der Ruhestrom beim Empfang niedrig, jedoch beim Senden verhältnismäßig hoch liegt. Der Ruhestrom ist mit der Umschaltung von Senden auf Empfang und umgekehrt über einen Umschalter (16) auf den der jeweiligen Betriebsart angepaßten Wert umschaltbar. Die Übergangsverzerrungen werden beim Senden mit einem entsprechenden höheren Ruhestrom unterdrükt, während beim Empfang eine noch ausreichende Sprachverständigung mit einem relativ geringeren Ruhestrom erreicht wird. Durch die relativ geringe mittlere Stromaufnahme werden die Größe und Aufwendigkeit des insbesondere mit Batterie oder Solarzellen betriebenen Geräts wesentlich herabgesetzt.

./...

Empfänger

NF-Verstärker und Modulator

Sender

FIG. 1

Die Erfindung betrifft ein Simplex-Sende-Empfangsgerät
mit einem Niederfrequenz-Leistungsverstärker, welcher
bei der Betriebsart "Empfang" die Modulation der empfangenen Hochfrequenzsignale verstärkt und bei der Betriebsart
"Senden" als Modulator für den Sender geschaltet ist und
eine mit Transistoren bestückte Gegentaktendstufe aufweist, in welche zur Reduzierung der Übergangsverzerrungen symmetrisch ein Ruhestrom eingeleitet ist.

Bei derartigen Sende-Empfangsgeräten wird der Niederfrequenz-
Leistungsverstärker zweifach genutzt. Bei der Betriebsart
"Empfang" dient der Niederfrequenzverstärker zum Betrieb
von Lautsprecher, Kopfhörer und dergl.. Bei der Betriebsart "Senden" wird der Niederfrequenzverstärker als Modulator für den Sender verwendet.

Um einen guten Wirkungsgrad zu erzielen, werden Niederfrequenz-Leistungsverstärker im allgemeinen in Parallel- oder
Serien-Gegentaktschaltung ausgeführt. Dabei werden die
positive und negative Halbwelle der Niederfrequenzspannung
von jeweils einem der beiden in der Gegentaktstufe verwendeten Transistoren erzeugt. Durch nicht zu vermeidende Schwankungen der Eigenschaften dieser beiden Transistoren treten
beim Nulldurchgang der Spannung mehr oder weniger große
Übergangsverzerrungen auf, die sich jedoch durch einen in
die Gegentaktendstufe symmetrisch eingespeisten  Ruhestrom
reduzieren lassen. Je größer der Ruhestrom eingestellt wird,
umso geringer sind die Übergangsverzerrungen.

Insbesondere bei batteriebetriebenen oder mit Solarzellen
gespeisten Sende-Empfangsgeräten ist jedoch die Stromaufnahme
ein entscheidender Faktor für Gerätevolumen, Gerätegewicht,
Betriebsdauer, Gerätekosten und Betriebskosten. Aus diesem Grunde kann der Ruhestrom nicht beliebig groß gemacht werden, ohne die sonstigen zu fordernden Eigenschaften des Gerätes wesentlich zu beeinträchtigen.

Bei der Betriebsart "Empfang" werden an die Qualität der Niederfrequenz-Ausgangsspannung relativ geringe Anforderungen gestellt. Bei einer noch ausreichenden Sprachverständigung können die Verzerrungen der Niederfrequenzspannung (Klirrfaktor) bis etwa 10 % ansteigen, wofür ein relativ geringer Transistor-Ruhestrom ausreicht.

Bei der Betriebsart "Senden" werden dagegen an die Qualität der Niederfrequenz-Spannung zur Modulation des Senders sehr hohe Anforderungen gestellt, weil zu hohe Verzerrungen die Bandbreite der Aussendung beeinflussen und dazu führen, daß die von den zuständigen Behörden festgelegten Werte überschritten werden können. Hierdurch kommt es zu nicht hinnehmbaren Störungen auf Nachbarkanälen. Zur Verwirklichung von minimalen Übergangsverzerrungen ist ein entsprechend hoher Transistor-Ruhestrom erforderlich.

Das Ziel der Erfindung besteht somit darin, ein Simplex-Sende-Empfangsgerät der eingangs genannten Gattung zu schaffen, bei dem die Gesamtstromaufnahme möglichst gering gehalten wird, ohne daß im Sendebtrieb übermäßige Übergangsverzerrungen hingenommen werden müssen.

Zur Lösung dieser Aufgabe sieht die Erfindung vor, daß der Ruhestrom des Niederfrequenz-Gegentakt-Leistungsverstärkers zusammen mit der Umschaltung Senden-Empfang auf einen der jeweiligen Betriebsart angepaßten Wert umschaltbar ist. Insbesondere ist der Ruhestrom des Niederfrequenz-Gegentakt-Leistungsverstärkers in der Betriebsart "Empfang" deutlich niedriger als in der Betriebsart "Senden".

Die Erfindung geht von der Erkenntnis aus, daß die Reduzierung des Ruhestroms im Betriebszustand "Empfang" sich
auf die mittlere Gesamtstromaufnahme des Gerätes besonders
stark auswirkt, da im praktischen Betrieb die Sende-Empfangsgeräte überwiegend im Betriebszustand "Empfang" oder "Empfangsbereitschaft" und nur relativ kurzzeitig im Betriebszustand
"Senden" betrieben werden. Der relativ hohe Ruhestrom in
der Betriebsart "Senden" wirkt sich auf die Gesamtstromaufnahme des Gerätes also trotz seiner für die Vermeidung von
Übergangsverzerrungen erforderlichen Größe nur relativ
gering auf den Gesamtstromverbrauch des Gerätes aus. Der
Ruhestrom in der Betriebsart "Empfang" wird wesentlich niedriger gehalten, so daß gerade noch eine annehmbare Sprachverständigung gewährleistet bleibt.

Vorteilhafterweise erfolgt die Umschaltung des Ruhestroms
mittels Relais oder Halbleiterschaltern.

Der Betrag des Ruhestroms des Niederfrequenz-Gegentakt-
Leistungsverstärkers ist in der Betriebsart "Empfang" bzw.
"Senden" durch zugeordnete Widerstände bestimmt.

Eine vorteilhafte praktische Lösung kennzeichnet sich dadurch, daß eine Stromversorgung direkt an den Symmetriepunkt des Ausgangstransformators und außerdem über die
parallel an einen Umschalter angelegten Widerstände an
den Symmetriepunkt des Eingangstransformators der Gegentaktendstufe angelegt ist. Die Widerstände sind zweckmäßigerweise einstellbar, um für jede Betriebsart den optimalen
Ruhestrom finden zu können, wobei bei der Betriebsart
"Empfang" auf einen möglichst geringen Ruhestrom und in
der Betriebsart "Senden" auf möglichst geringe Übergangsverzerrungen zu achten ist.

Die Erfindung wird im folgenden beispielsweise anhand der
Zeichnung beschrieben; in dieser zeigt:

Figur 1    ein schematisches Blockschaltbild eines
           erfindungsgemäßen Simplex-Sende-Empfangsgerätes,

Figur 2    ein Schaltbild des bei dem erfindungsgemäßen
           Gerät verwendeten Niederfrequenz-Gegentakt-
           Leistungsverstärkers und die
Fig. 3-5   weitere Ausführungsbeispiele.

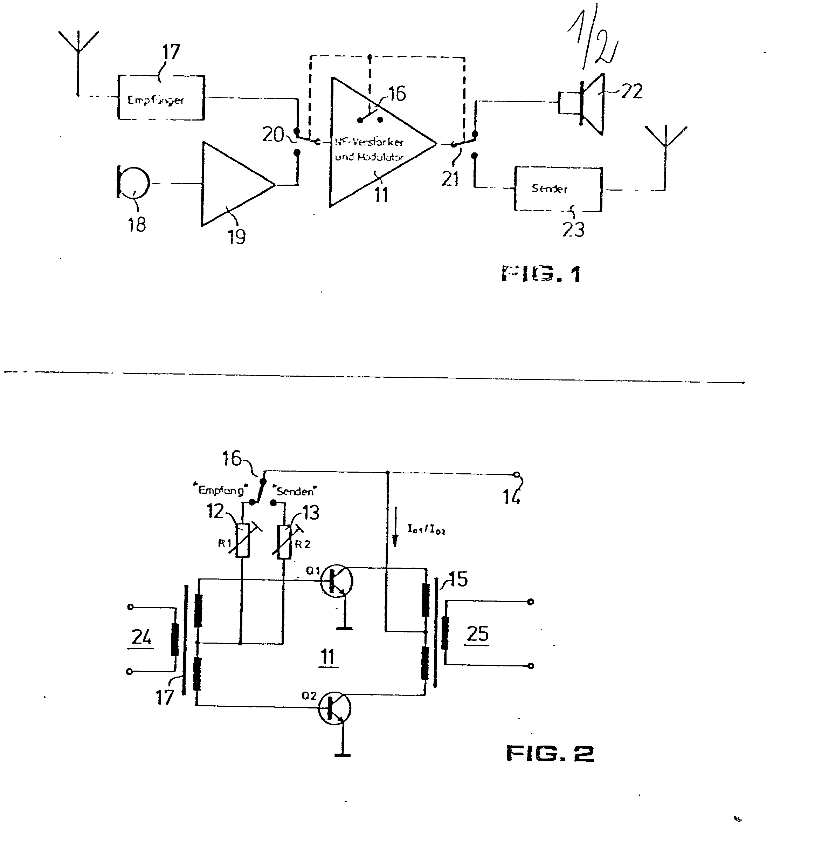

Nach Fig. 1 sind ein Empfänger 17 und ein Mikrofon 18 über
einen Verstärker 19 an einen ersten Umschalter 20 angelegt,
welcher es gestattet, wahlweise den Empfänger 17 oder den
Mikrofonverstärker 19 an einen Niederfrequenz-Gegentakt-
leistungsverstärker 11 anzuschließen, welcher im Sendebetrieb als Modulator wirkt.

Der Ausgang des Verstärkers 11 ist über einen weiteren
Umschalter 21 wahlweise an einen Lautsprecher 22 oder
einen Sender 23 anlegbar.

Die Umschalter 20, 21 sind mechanisch derart gekuppelt,
daß die Umschaltung von der Betriebsart "Empfang" auf die
Betriebsart "Senden" und umgekehrt gleichzeitig erfolgt.
Dies ist in Fig. 1 durch eine gestrichelte Verbindungslinie zwischen den beiden Umschaltern 20, 21 angedeutet.

In Fig. 2 ist der Aufbau des Leistungsverstärkers 11 im
einzelnen wiedergegeben.

An einen Eingangstransformator einer Gegentaktendstufe
sind parallel zwei Transistoren Q1, Q2 angeschlossen,
deren Kollektoren am Ausgangstransformator 15 der Gegentaktendstufe anliegen. Die Schaltung und Dimensionierung
der einzelnen Elemente ist derart, daß die positive Halbwelle der bei 24 angelegten Niederfrequenzspannung vom
Transistor Q1 und die negative Halbwelle vom Transistor
Q2 erzeugt wird.

Aufgrund von geringfügigen Unterschieden in den Eigenschaften der beiden Transistoren treten jedoch beim Nulldurchgang der Spannung Übergangsverzerrungen auf. Zur Verringerung dieser Übergangsverzerrungen wird dem Symmetriepunkt
des Ausgangstransformators 15 von einer Stromversorgung
14 ein Ruhestrom $I_o$ zugeführt. Außerdem ist die Stromversorgung 14 über einen Umschalter 16 wahlweise über einen
Einstellwiderstand 12 oder einen Einstellwiderstand 13
an den Symmetriepunkt des Eingangstransformators 17 anschließbar.

Bei der dargestellten Schaltstellung des Umschalters 16
"Empfang" fließt zum Symmetriepunkt des Ausgangstransformators 15 ein relativ niedriger Ruhestrom $I_{o1}$. Der Ruhestrom
$I_{o1}$ ist gerade so groß, wie dies für eine Sprachveständigung
erforderlich ist. Die Verzerrungen der Niederfrequenzspannung am Ausgang 25 können dabei bis etwa 10 % ansteigen.
Dies gewährleistet einen für die Gesamtstromaufnahme
des Gerätes annehmbaren geringen Ruhestromwert. Der optimale Wert für den Ruhestrom $I_{o1}$ wird durch entsprechende
Einstellung des Einstellwiderstandes 12 gewählt.

Nach dem Umschalten des Umschalters 16 auf die Betriebsart "Senden" wird durch geeignete Einstellung des Einstellwiderstandes 13 ein wesentlich höherer Ruhestrom $I_{o2}$ gewählt.
Der Ruhestrom $I_{o2}$ wird auf einen so hohen Wert eingestellt,
daß die Übergangsverzerrungen am Ausgang 25 einen vorgegebenen zulässigen Wert nicht überschreiten.

0023275

Der Ruhestrom $I_o$ in der Parallel-Gegentakt-Leistungsstufe 11
wird aufgrund der erfindungsgemäßen Schaltung von der Stromversorgung 14 über den Symmetriepunkt des Ausgangstransformators 15 symmetrisch über die Transistoren Q1, Q2 zur Stromversorgung zurückfließen, ohne daß dabei Ohm'sche Spannungsabfälle entstehen. Diese würden den Wirkungsgrad erheblich
verschlechtern. Die Ruhestromeinstellung wird daher auf den
Basiskreis der Transistoren Q1, Q2 verlegt.

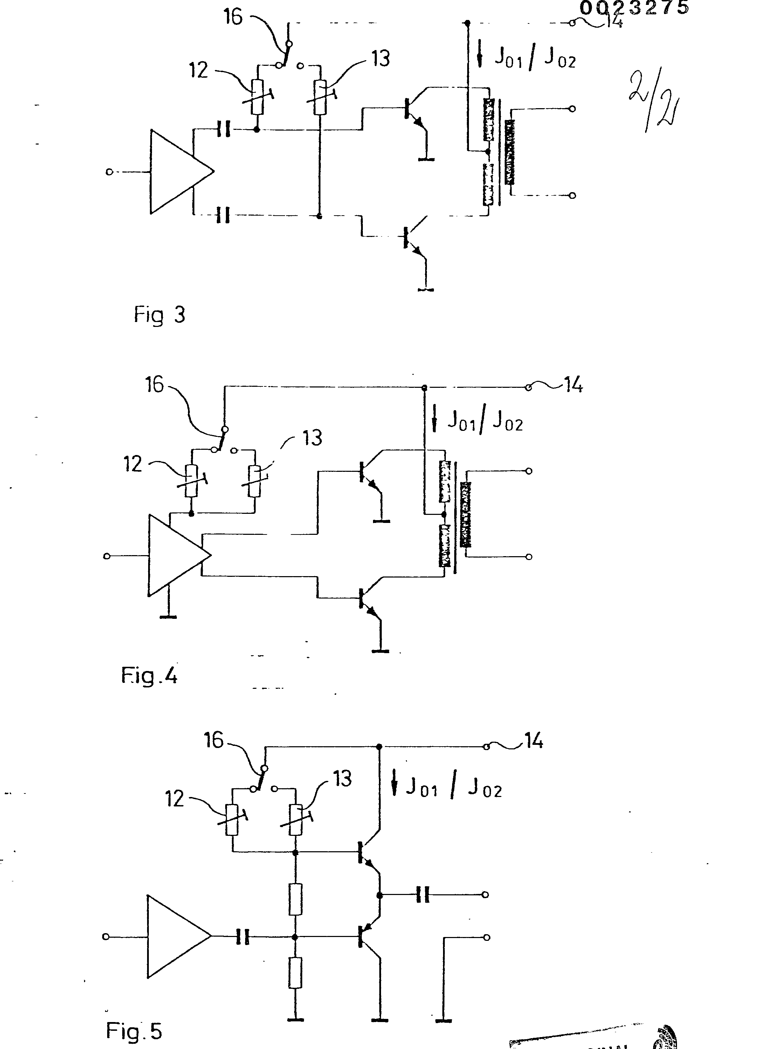

Die Fig. 3 und 4 zeigen weitere Ausführungsbeispiele der Gegentakt-Leistungsstufe 11, wobei der Eingangstransformator 17 durch
einen Vorverstärker 17' mit gegenphasigen Ausgängen mit bzw.
ohne Trennkondensatoren ersetzt ist.

Fig. 5 zeigt eine Serien-Gegentaktschaltung 11, bei der der
Eingangstransformator durch einen Trennkondensator 17" ersetzt
ist.

Sofern der Vorverstärker ohne Trennkondensator betrieben wird,
erfolgt die Ruhestromeinstellung über den Vorverstärker gemäß
Fig. 4.

In Fig. 1 ist durch eine weitere gestrichelte Linie angedeutet,
daß der Umschalter 16 mit den Umschaltern 20, 21 derart gekuppelt ist, daß sämtliche Umschalter zur gleichen Zeit automatisch
betätigt werden. Dies kann mechanisch geschehen, erfolgt aber
vorzugsweise durch Relais oder Halbleiterschalter.

Simplex-Sende-Empfangsgerät

Patentansprüche :

1. Simplex-Sende-Empfangsgerät mit einem Niederfrequenz-Leistungsverstärker, welcher bei der Betriebsart "Empfang" die Modulation der empfangenen Hochfrequenzsignale verstärkt und bei der Betriebsart "Senden" als Modulator für den Sender geschaltet ist und eine mit Transistoren bestückte Gegentaktendstufe aufweist, in welche zur Reduzierung der Übergangsverzerrungen symmetrisch ein Ruhestrom eingeleitet ist, dadurch gekennzeichnet, daß der Ruhestrom $(I_o)$ des Niederfrequenz-Gegentakt-Leistungsverstärkers (11) zusammen mit der Umschaltung Senden-Empfang auf einen der jeweiligen Betriebsart angepaßten Wert umschaltbar ist.

2. Gerät nach Anspruch 1, dadurch gekennzeichnet, daß der Ruhestrom des Niederfrequenz-Gegentakt-Leistungsverstärkers (11) in der Betriebsart "Empfang" deutlich niedriger ist als in der Betriebsart "Senden".

3. Gerät nach Anspruch 1 oder 2, dadurch g e k e n n z e i c h - n e t , daß die Umschaltung des Ruhestromes des Niederfrequenz-Gegentakt-Leistungsverstärkers (11) mittels Relais oder Halbleiterschaltern erfolgt.

4. Gerät nach einem der vorhergehenden Ansprüche, dadurch g e k e n n z e i c h n e t , daß der Betrag des Ruhestroms des Niederfrequenz-Gegentakt-Leistungsvestärkers (11) in der Betriebsart "Empfang" bzw. "Senden" durch zugeordnete Widerstände (12, 13) bestimmt ist.

5. Gerät nach Anspruch 4, dadurch g e k e n n z e i c h n e t , daß eine Stromversorgung (14) direkt an den Symmetriepunkt des Ausgangstransformators (15) und außerdem über die parallel an einen Umschalter (16) angelegten Widerstände (12, 13) an den Symmetriepunkt des Eingangstransformators (17) der Gegentaktstufe angelegt ist.

6. Gerät nach Anspruch 4 oder 5, dadurch g e k e n n z e i c h - n e t , daß die Widerstände (12, 13) einstellbar sind.

FIG. 1

FIG. 2

0023275

2/2

Fig 3

Fig.4

Fig.5

0023275

Europäisches
Patentamt

EUROPÄISCHER RECHERCHENBERICHT

Nummer der Anmeldung

EP 80103705.2

| Kategorie | EINSCHLÄGIGE DOKUMENTE | | KLASSIFIKATION DER ANMELDUNG (Int. Cl.) |
|---|---|---|---|
| | Kennzeichnung des Dokuments mit Angabe. soweit erforderlich, der maßgeblichen Teile | betrifft Anspruch | |
| | DE - B2 - 2 365 289 (NIPPON GAKKI SEIZO)<br><br>+ Fig. 1; Spalte 2, Zeile 63 bis Spalte 3, Zeile 3; Spalte 5, Zeile 17 bis Spalte 6, Zeile 24 +<br><br>-- | 1,4,6 | H 04 B 1/40<br>H 03 F 3/26 |
| A | GB - A - 1 504 576 (RONALD TRADING)<br><br>+ Fig. 2; Seite 1, Zeilen 44-63; Seite 2, Zeilen 39-49 +<br><br>-- | 1 | |
| A | US - A - 4 060 765 (SANYO ELECTRIC)<br><br>+ Fig. 1; Spalte 3, Zeile 26 bis Spalte 4, Zeile 2 +<br><br>---- | 1 | RECHERCHIERTE SACHGEBIETE (Int. Cl.)<br><br>H 03 F 1/00<br>H 03 F 3/00<br>H 04 B 1/00 |

KATEGORIE DER GENANNTEN DOKUMENTE

X: von besonderer Bedeutung
A: technologischer Hintergrund
O: nichtschriftliche Offenbarung
P: Zwischenliteratur
T: der Erfindung zugrunde liegende Theorien oder Grundsätze
E: kollidierende Anmeldung
D: in der Anmeldung angeführtes Dokument
L: aus andern Gründen angeführtes Dokument
&: Mitglied der gleichen Patentfamilie, übereinstimmendes Dokument

| X | Der vorliegende Recherchenbericht wurde für alle Patentansprüche erstellt. |
|---|---|

| Recherchenort | Abschlußdatum der Recherche | Prüfer |
|---|---|---|
| WIEN | 06-10-1980 | DRÖSCHER |

EPA form 1503.1   06.78